# EUROPEAN PATENT APPLICATION

(11) **EP 4 546 021 A1**
(43) Date of publication of application: **30.04.2025**
(21) Application number: 24207315.3
(22) Date of filing: 17.10.2024
(51) Int. Cl.: G02B 6/42

(54) **THERMAL DISSIPATION-ENHANCED OPTICAL MODULE AND OPTICAL COMMUNICATION SYSTEM INCLUDING THE SAME**

(30) Priority: 23.10.2023 KR 20230142108; 28.11.2023 KR 20230167951
(71) Applicant: Lessengers Inc., Pohang-si, Gyeongsangbuk-do 37666 (KR)
(72) Inventor: KIM, Taeyong, 37668 Pohang-si (KR); KIM, Manjae, 37668 Pohang-si (KR); KIM, Chongcook, 37668 Pohang-si (KR)
(74) Representative: Fuchs Patentanwälte Partnerschaft mbB

(57) **Abstract**

Embodiments disclose an optical module and an optical communication system including the same, the optical module including a substrate, an optical component positioned on the substrate and converting an electrical signal into an optical signal or converting an optical into an electrical signal, an electronic component driving the optical component, an optical fiber support fixing an optical fiber positioned away from the optical component, an optical wire optically connecting the optical component and one end of the optical fiber, a container accommodating the optical component, the electronic component, and the optical fiber and isolated from the outside, and coolant filled in the container, wherein the electronic component, the optical component, and the optical wire contact the coolant.

## Description

### CROSS REFERENCE TO RELATED APPLICATION

The present application claims priority to Korean Patent Applications No. 10-2023-0142108, filed October 23, 2023 and No. 10-2023-0167951, filed November 28, 2023, the entire contents of which is incorporated herein for all purposes by this reference.

### BACKGROUND OF THE INVENTION

### Field of the Invention

Embodiments relate to a thermal dissipation-enhanced optical module and an optical communication system including the same.

### Description of the Related Art

Based on their destination at data centers, global Internet traffic can be classified into three categories: intra-data center traffic, inter-data center traffic, and data center-to-end user traffic. Among the three types of data traffic, intra-data center traffic accounts for the largest proportion. The majority of global data generated worldwide originates from the production, processing, storage, and authentication of data within data centers, and with the expansion of applications in artificial intelligence (Al), machine learning (ML), and big data, the data traffic within data centers is steadily increasing day by day.

One way to efficiently handle the rapidly increasing intra-data center traffic is to expand the use of data center optical interconnect solutions, i.e., the expansion of optical modules within data centers. The applicable area of optical modules is gradually expanding with the development of optical communication technology and the increase in data traffic.

The trends toward high-speed, high-capacity, and high-density increase the complexity of technologies adopted in optical modules and necessitate higher power consumption.

The typical power consumption of the 200G optical module commonly used in artificial intelligence and machine learning clusters is around 5W, and it operates at temperatures exceeding 40°C in a conventional data center environment.

For next-generation optical modules, they require even greater power consumption, generating more heat in proportion to the increasing power demands. The elevated operating temperature of optical modules can not only impact the optical signal transmission and reception performance but also compromise the reliability and lifespan of the optical module.

Therefore, there is a need for optical modules that are excellent in thermal dissipation and economically viable for mass production, without compromising the reliability and lifespan.

### SUMMARY OF THE INVENTION

Embodiments provide an optical module with enhanced thermal dissipation performance.

According to one aspect of the present invention, an optical module include a substrate, an optical component positioned on the substrate and converting an electrical signal into an optical signal or converting an optical into an electrical signal, an electronic component driving the optical component, an optical fiber support fixing an optical fiber positioned away from the optical component, an optical wire optically connecting the optical component and one end of the optical fiber, a container accommodating the optical component, the electronic component, and the optical fiber and isolated from the outside, and coolant filled in the container, wherein the electronic component, the optical component, and the optical wire contact the coolant.

### BRIEF DESCRIPTION OF THE DRAWINGS

FIG. 1 is a perspective view of an optical module according to an embodiment of the present invention;
FIG. 2 is a perspective view of an optical module according to an embodiment of the present invention viewed from a different direction;
FIG. 3 is an exploded perspective view of an optical module according to an embodiment of the present invention;
FIG. 4 is an enlarged view of part A of FIG. 3;
FIG. 5 is an enlarged view of part B of FIG. 4;
FIG. 6 is a diagram illustrating an optical connection state between an optical component and an optical fiber through an optical wire;
FIG. 7 is a diagram illustrating a state in which coolant is injected into a container;
FIG. 8 is a diagram illustrating a partition and a heat dissipation pattern formed on a first housing;
FIG. 9 is a diagram illustrating a container according to another embodiment of the present invention;
FIG. 10 is a diagram illustrating a state in which the coolant contained in a container is circulating to the outside;
FIG. 11 is a diagram illustrating a state in which coolant is injected into a conventional optical module structure;
FIG. 12A is a diagram illustrating the simulation results of a cooling performance of an optical module according to a conventional structure;
and FIG. 12B is a diagram illustrating the simulation results of a cooling performance of an optical module according to an embodiment of the present invention;
FIG. 13 is a diagram illustrating an optical module in which two optical couplers formed on the same substrate are connected by an optical wire;
FIG. 14 is a diagram illustrating an optical module in which two multichannel optical components formed on different substrates are connected by a plurality of optical wires;
FIG. 15 is a diagram illustrating an optical module in which a plurality of multichannel optical components are connected by a plurality of optical wires; and
FIG. 16 is a diagram illustrating an optical communication system according to an embodiment of the present invention.

### DETAILED DESCRIPTION OF THE INVENTION

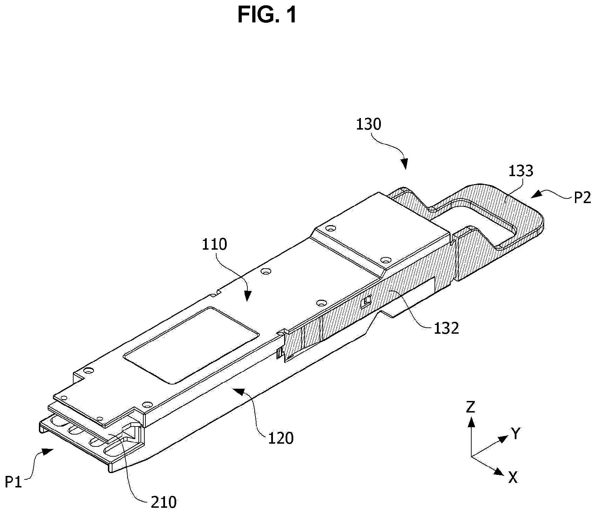

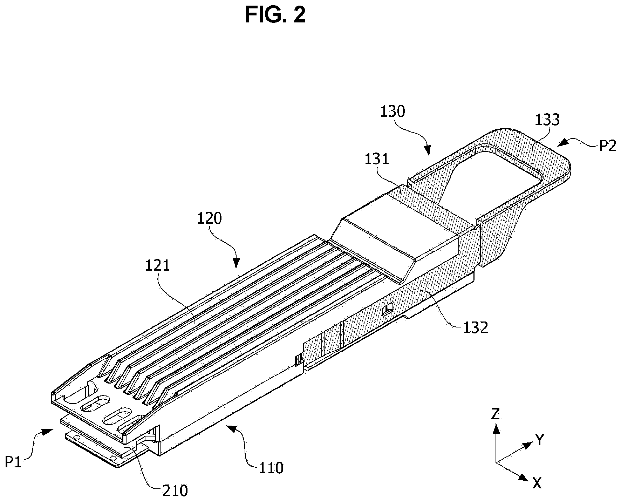

With reference to FIGS. 1 and 2, the optical module according to an embodiment may include a housing 110 and 120, a substrate 210 placed inside the housing 110 and 120, and a holder 130 placed at one end of the housing 110 and 120.

The optical module may be of quad small form-factor pluggable (QSFP), QSFP double density (QSFP-DD), or octal small form-factor pluggable (OSFP) types, but it is not limited to these and may also be various types of optical modules that comply with the multiple source agreement (MSA) standards.

The housing 110 and 120 may be extended to a predetermined length to have one end P1 and the opposite end P2 and produced by assembling a first housing 110 and a second housing 120. The first housing 110 may form one side of the housing, and the second housing 120 may form the other side of the housing. However, the housing may also be manufactured as a single integrated unit without being limited to this configuration. The housing may be made of a material conducive to heat dissipation, but this is not a strict requirement. The second housing 120 or the first housing 110 may be provided with a plurality of heat pins 121 on the outer surface thereof.

The holder 130 may include a coupling portion 131 coupled to one end of the housing, a pair of sliding portions 132 extending to one end P1 of the housing, and a handle 133 extending to the opposite end P2 of the housing.

The coupling portion 131 is coupled to one end P1 of the housing, and the sliding portions 132 may be moved in the first direction (Y-axis direction) via the handle 133. The handle 133 may be positioned at the opposite end P2 of the coupling portion 131. The handle 133 may transmit the force applied by the user to the holder 130. That is, when the user pulls the handle 133, the coupling portion 131 and the sliding portions 132 may move in the pulled direction.

The user may insert an optical fiber module (not shown) into the opposite end P2 of the housing. The user may also detach the optical fiber module from the optical module after pulling the handle 133.

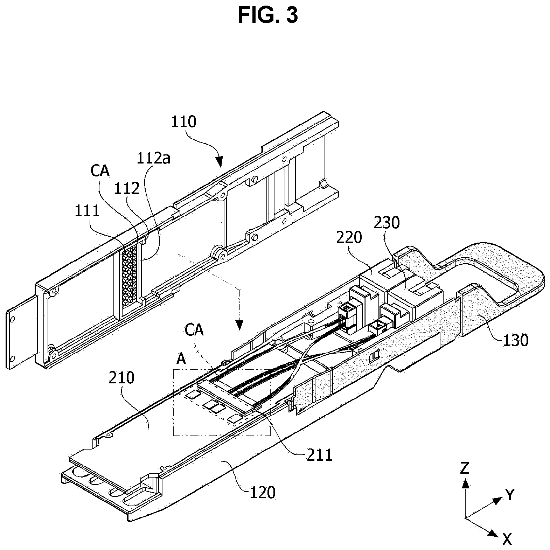

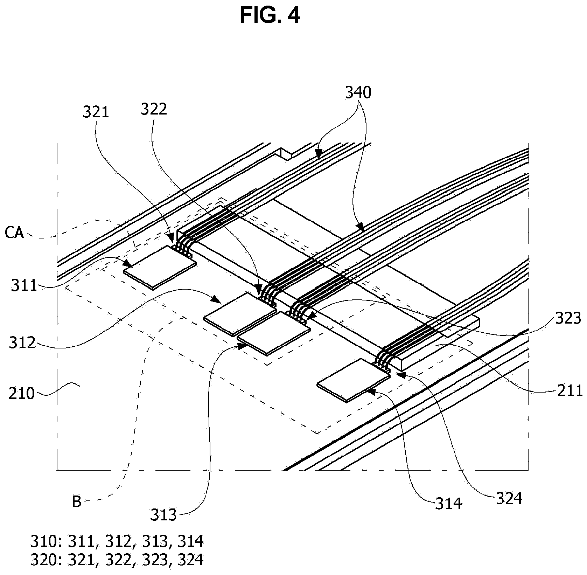

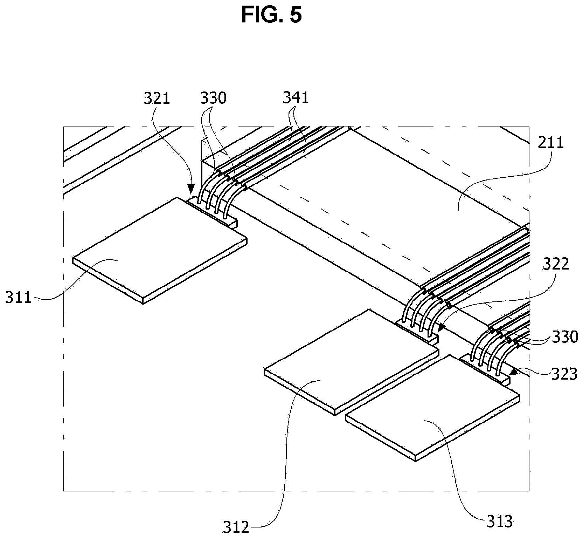

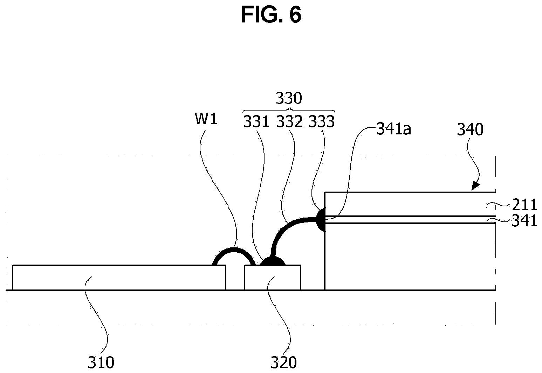

FIG. 3 is an exploded perspective view of an optical module according to an embodiment of the present invention. FIG. 4 is an enlarged view of part A of FIG. 3. FIG. 5 is an enlarged view of part B of FIG. 4. FIG. 6 is a diagram illustrating an optical connection state between an optical component and an optical fiber through an optical wire.

With reference to FIGS. 3 to 5, at least one electronic component 310 is disposed on the substrate 210, and a plurality of optical components 320 may be disposed around the electronic component 310. The optical components 320 and electronic components 310 may be electrically connected via a wire W1.

The electronic component 310 may drive a light-emitting component according to a signal received from an external host or convert the optical signal received from a light-receiving component into an electrical signal and transmit the electrical signal to the host. The electronic component 310 may be a semiconductor integrated circuit that drives the optical component 320 at high speeds, this is not a strict requirement.

In an embodiment, the first to fourth electronic components 311, 312, 313, and 314 may be connected to respective optical components 321, 322, 323, and 324. Although the embodiment illustrates one electronic component connected to one optical component, this configuration is not a strict requirement, and one electronic component may be connected to a plurality of optical components.

The optical component 320 may be a variety of optical devices capable of emitting or receiving light, such as a photonic integrated circuit chip (PIC), optical coupler, light-emitting diode, or light-receiving diode. For example, the optical component 320 may include a light-emitting diode emitting laser light according to the drive signal output from the electronic component 310 and a light-receiving diode receiving external light.

The optical component 320 may be optically connected to the end of an exposed optical fiber 341 in the optical fiber support 340 through an optical wire 330. A plurality of optical fibers 341 may extend to the sockets 220 and 230 to which external optical fiber modules (not shown) are coupled. Therefore, when an external optical fiber module is inserted into the sockets 220 and 230, the external optical fiber module may be optically connected to the optical component 320. Consequently, the optical component 320 may transmit signals to the outside and receive signals from the outside.

With reference to FIG. 6, the optical wire 330 connecting the optical component 320 and the optical fiber 341 may be made of a transparent material and configured as a single wire shape with one end and the other end. The material of the optical wire 330 may be selected from various materials that can form a meniscus and cure under ultraviolet light.

For example, the material of the optical wire 330 may be polystyrene, polymethyl methacrylate, polycarbonate, perfluorinated compounds (PFCs) such as amorphous fluoropolymer (CYTOP), or epoxy such as polyimide or SU-8.

In addition, the material of the optical wire 330 may be organic conductive polymer (π-conjugated polymer), which has the advantage of being able to freely adjust their electrical and optical properties through chemical doping.

The solvent for the optical wire 330 solution may be a substance that evaporates easily (volatile substance), and any material used in the relevant technical field may be selected without limitation.

A method for forming the optical wire 330 is to move a micro-pipette with the optical wire 330 solution deposited on the optical component 320 onto the end 341a of the optical fiber 341 to form a continuous optical wire 330 between the end 341a of the optical component 320 and the end 341a of the optical fiber 341. Subsequently, the optical wire 330 may be cured to maintain its shape. Therefore, signals transmitted from the optical component 320 may be transmitted to the optical fiber 341 through the optical wire 330 without loss, and signals received through the optical fiber 341 may be transmitted to the optical component 320 through the optical wire 330 without loss.

The optical wire 330 may include a first bulge 331 formed on the optical component 320, a second bulge 333 formed on the end 341a of the optical fiber 341, and a channel portion 332 connecting the first bulge 331 and the second bulge 333. For example, the first bulge 331 and the second bulge 333 may include a layer with a different refractive index than the channel portion 332 for optical matching.

The shape of the optical wire 330 may vary depending on the position of the component to be connected. Various connection structures between optical components and optical wires are described later.

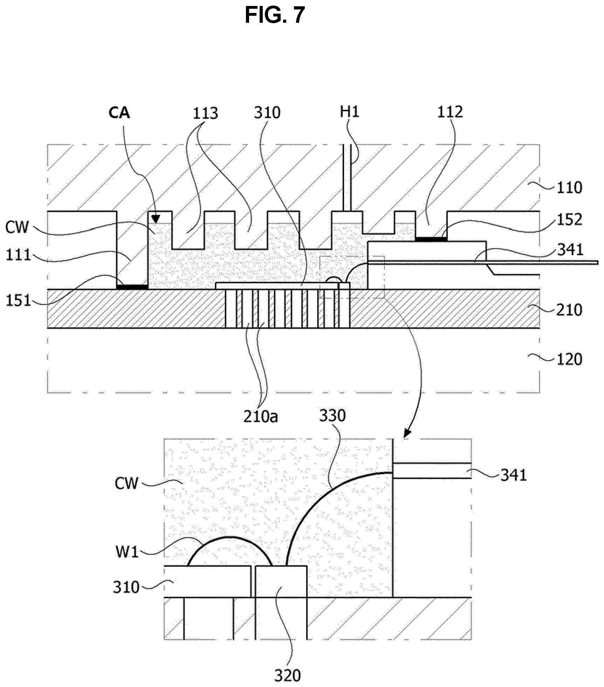

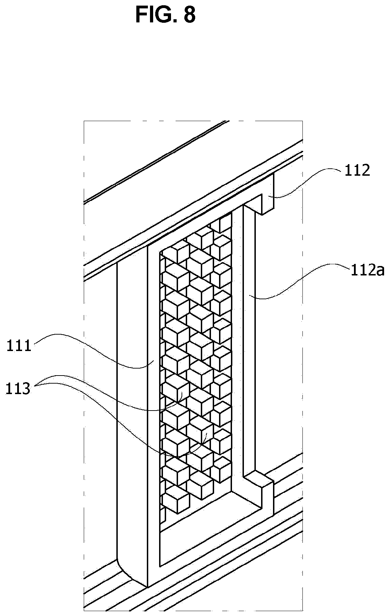

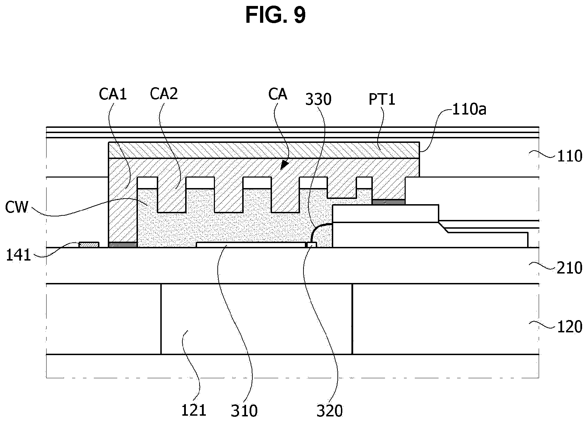

FIG. 7 is a diagram illustrating a state in which coolant is injected into a container. FIG. 8 is a diagram illustrating a partition and a heat dissipation pattern formed on a first housing. FIG. 9 is a diagram illustrating a container according to another embodiment of the present invention.

With reference to FIGS. 7 and 8, a container (CA) may be provided on the substrate 210 to accommodate the electronic component 310, optical component 320, optical wire 330, and the end of the optical fiber 341. The container (CA) may be a compartment isolated from the outside to accommodate coolant (CW).

The container (CA) may be formed by the protruding partitions 111 and 112 from the first housing 110 being connected to the substrate 210 and the optical fiber support 340. That is, the internal space of the container (CA) may be defined by the protruding partitions 111 and 112, the substrate 210, and the optical fiber support 340. An adhesive layer 151 and 152 may be formed between the partitions 111 and 112 and the substrate 210 to seal the internal space of the container (CA) from the outside.

The partitions 111 and 112 may be formed to surround the electronic component 310, the optical component 320, and the end of the optical wire 330, and optical fiber 341, and they include a first partition 111 with a first length to be coupled to the substrate 210 and a second partition 112 with a second length to be coupled to the upper surface of the optical fiber support 340.

The container CA may be filled with coolant CW. The coolant CW may be any of include various cooling fluids commonly used. The coolant CW may directly contact and exchange heat with the electronic component 310, optical component 320, optical wire 330, and optical fiber 341. In particular, the electronic component 310 and the optical component 320, which generate the most heat, may rapidly dissipate heat through the coolant CW, thereby enhancing the cooling performance. Consequently, it is possible to prevent performance degradation of the electronic component 310 and stabilize the output wavelength of the optical component 320.

The first housing 110 may include a plurality of heat dissipation patterns 113 arranged between the first partition 111 and the second partition 112. The second partition 112 may have a cutout 112a formed to accommodate the optical fiber support 340.

The heat dissipation patterns 113 may protrude towards the substrate 210 and directly contact the coolant CW, allowing the heat of the coolant CW to be released to the outside. The first housing 110 may include a plurality of heat fins (not shown) formed on the outer surface thereof to expel heat to the outside.

The first housing 110 or the second housing 120 may include a hole H1 for injecting coolant CW into the container CA and a cap (not shown) covering the hole H1. Therefore, after assembling the first housing 110 and the second housing 120, coolant CW may be injected through the hole H1. The cap may be opened to replenish the coolant CW in case of evaporation. In addition, when the optical module is inserted into a body filled with coolant, the cap may be omitted. In this case, when the optical module is inserted into the body, the coolant in the body may be charged into the container through the opening hole. In this structure, electrical and/or physical problems caused by coolant (e.g., shorts) can be eliminated in advance.

However, this configuration is not a strict requirement, and the container CA may be sealed after the coolant CW is injected during the initial assembly without forming the hole or cap. For example, the coolant CW may be accommodated in the container CA by filling the coolant CW in the container CA, which is in the state of being inverted by flipping the first housing 110 upside down, and coupling the second housing 120 assembled with the substrate 210 to the inverted first housing 110.

The substrate 210 may be provided with via holes 210a formed to dissipate the heat generated by the electronic component 310. The described configuration enables the dissipation of heat from the upper part of the electronic component 310 through the coolant CW and from the lower part of the electronic component 310 through the via holes 210a, thereby enhancing the heat dissipation performance of the optical component 310. Optionally, additional cooling components, such as a Peltier module (not shown), may be placed on the bottom of the electronic component 310.

The container CA may include a material or structure capable of withstanding volume changes caused by internal thermal expansion or contraction. For example, the container may be made of a material capable of withstanding thermal expansion or contraction or may be structured with multiple walls.

With reference to FIG. 9, an additional container CA may be formed on the substrate 210. That is, the container CA may have a structure separate from the first housing. The container CA may be assembled on the substrate 210 and have a rectangular shape open at the bottom. After placing the substrate 210 in the second housing 120, the container CA may be assembled on the substrate 210. A separate hole (not shown) for injecting coolant CW and a cap (not shown) covering the hole may be arranged on the top surface of the container CA.

A cooling module such as a Peltier module PT1 may be arranged on the upper surface of the container CA. This configuration may allow for rapid dissipation of heat from the coolant.

In addition, a sensor 141 for detecting leaks may be arranged on the exterior of the container CA. The sensor 141 may generate an alarm signal upon detecting a leakage of coolant to the exterior.

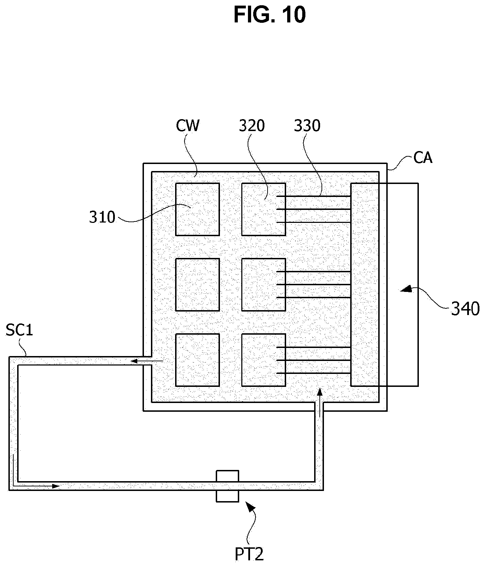

With reference to FIG. 10, the container CA may be connected to a channel SC1 circulating externally within the optical module. With this configuration, the coolant CWfrom the container (CA) circulates externally through the channel (SC1) in contact with the housing, facilitating rapid heat dissipation. In addition, a separate cooling module PT2 may be arranged on the channel SC1.

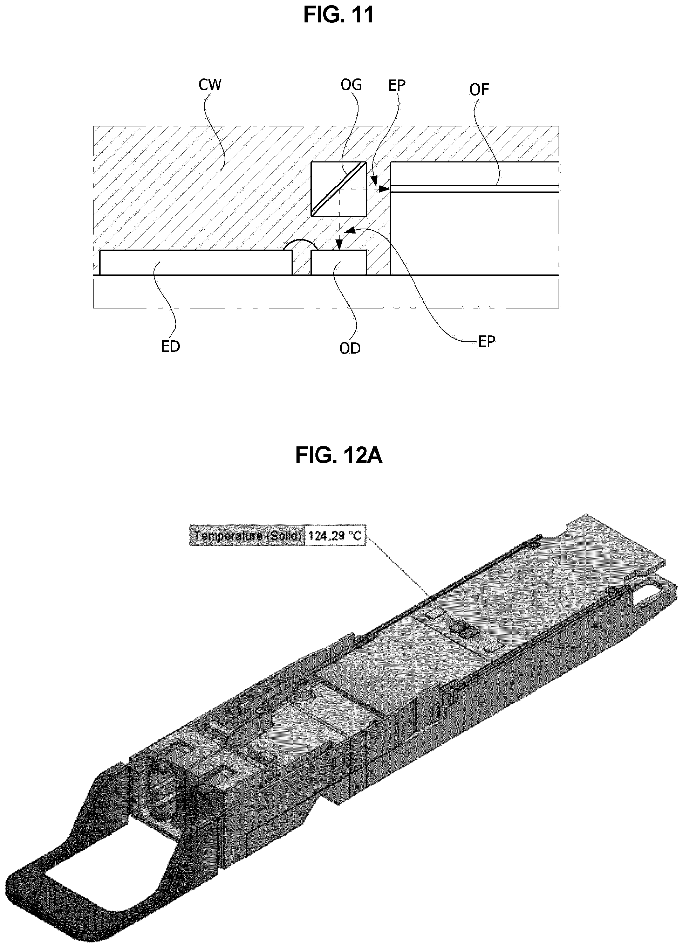

FIG. 11 is a diagram illustrating a state in which coolant is injected into a conventional optical module structure.

With reference to FIG. 11, the conventional optical module has a structure that uses a prism lens OG or the like to change the direction of the light emitted from the laser device OD and focus the light on the optical fiber OF. This optical coupling structure encounters challenges in optical coupling when coolant CW fills the spaces EP between the laser component OD and the prism lens OG, as well as between the prism lens OG and the optical fiber OF, due to changes in refractive index. Therefore, it is difficult to adopt a structure that directly contacts the optical component 320 with coolant CW in the conventional lens-based optical coupling method.

However, according to the embodiment, the issue of optical coupling disruption caused by the presence of coolant CWcan be avoided by using an optical wire 330 to establish a direct connection between the optical component 320 and the optical fiber 341.

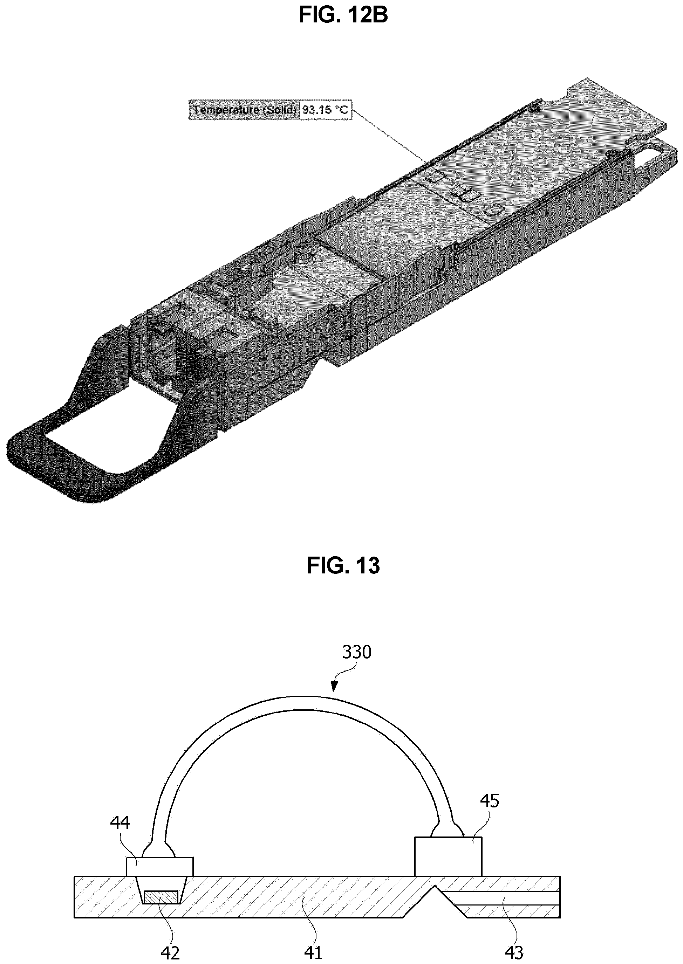

With reference to FIG. 12A and FIG. 12B, the optical module was placed inside a duct with a fan, and air was blown to measure the cooling efficiency by coolant CW.

The simulation was conducted using an optical module equipped with one 800G retimer with eight channels (power consumption: 8W), two 4ch VCSEL drivers (power consumption: 3W), two 4ch TIAs (power consumption: 3W), two Quad VCSEL arrays (power consumption: 0.05W), and two Quad PD arrays (power consumption: 0.01W).

The simulation results showed that the temperature of the substrate 210 in the conventional structure rose to 124.9°C as shown in FIG. 12A, while the temperature of the substrate 210 in the optical module according to the present invention was reduced to 93.15°C as shown in FIG. 12B.

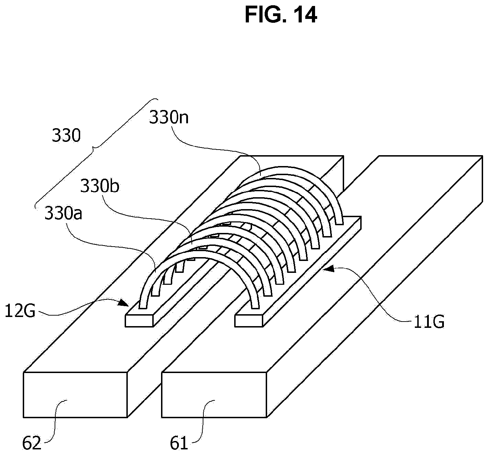

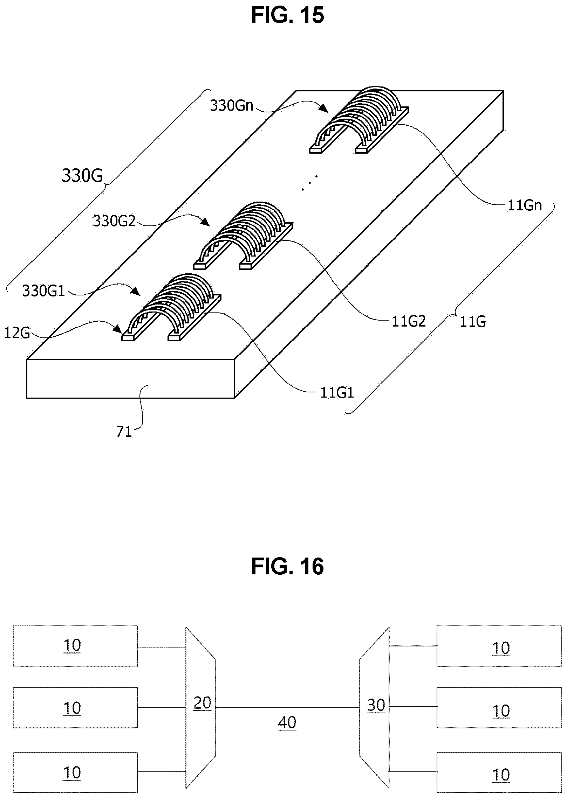

FIG. 13 is a diagram illustrating an optical module in which two optical couplers formed on the same substrate are connected by an optical wire. FIG. 14 is a diagram illustrating an optical module in which two multichannel optical components formed on different substrates are connected by a plurality of optical wires. FIG. 15 is a diagram illustrating an optical module in which a plurality of multichannel optical components are connected by a plurality of optical wires.

With reference to FIG. 13, the optical module includes an optical interposer 41, an optical component 42, an optical waveguide 43, and an optical wire 330.

The optical interposer 41 refers to a platform formed by including a plurality of electronic components 310 and a plurality of optical components 320 to help transmit electrical signals and optical signals. Here, the electronic components 310 include various signal processing circuit elements such as signal generators, amplifiers, modulators, demodulators, frequency converters, linearizers, and voltage converters, which may be manufactured using compound or silicon process technologies.

The optical component 42 encompasses semiconductor laser diodes, photodiodes, optical modulators, optical demodulators, optical multiplexers, optical demultiplexers, filters, reflectors, lenses, optical waveguides, optical couplers, and so on.

The first optical coupler 44, which is a structure for transmitting an optical signal received from an optical component 42 to an optical wire 330, may be designed in consideration of at least one of the geometrical characteristics or wave characteristics of the optical signal received from the optical component 42.

The geometric characteristics of the optical signal include characteristics expressed in 2-dimensional (2D) or 3D considering straightness, reflection, refraction, and the like. For example, when the optical signal received from the optical component 42 spreads with a specific radiation angle, the spreading optical signal may be collected or converted into a form of optical signal that propagates in parallel to transmit to the optical wire 330.

In addition, the first optical coupler 44 may be designed in consideration of the wave dynamic characteristics of the optical signal. For example, the first optical coupler 44 may include a grating coupler designed to transmit the optical signal received from the optical component 42 to the optical wire 330.

The second optical coupler 45, which is a structure for transmitting an optical signal passed through the optical wire 330 to a preset optical component 320 or to the outside, may be designed considering at least one or both of the geometrical and wave characteristics of the optical passed through the optical wire 330.

The optical waveguide 43 may include a core and cladding to effectively transmit the optical signal received from the second optical coupler 45 to the outside without noise and loss. Here, the core and cladding of the optical waveguide 43 may be designed considering the wavelength of the optical signal generated, emitted, or transmitted from the optical component 42.

The optical waveguide 43 may be formed of the same material as the optical wire 330, and the end portion of the optical waveguide 43 in close contact with the second optical coupler 45 may be designed considering the characteristics of the optical signal transmitted from the second optical coupler 45.

With reference to FIG. 14, the optical module may include a first substrate 61, a second substrate 62, a first optical component group 11G, a second optical component group 12G, and an optical wire group 330G.

With reference to FIG. 15, the first optical component group 11G may be divided into a plurality of first unit group 11G1, 11G2, and 11Gn, and similarly, the second optical component group 12G may also be divided into a plurality of second unit groups. The optical wire group 330G may be divided into a plurality of sub-wire groups 330G1, 330G2, and 330Gn based on the input and output counts of the unit groups of the first and second optical component groups 11G and 12G.

With reference to FIG. 16, the optical communication system can be defined as a system that communicates using a plurality of optical modules, and although wavelength division multiplexing (WDM) transmission is provided as an example, it is not strictly limited to that, and various other optical communication methods can be adopted.

The wavelength division multiplexing transmission method refers to the technique of multiplexing a plurality of wavelength signals into a single signal and transmitting the multiplexed signal through a single optical fiber. The wavelength division multiplexing transmission method can be utilized not only in long-haul transmission networks but also in the field of short-distance Ethernet transmission. For example, the wavelength division multiplexing (WDM) transmission method can transmit high-capacity Ethernet signals through single-mode and multi-mode optical fibers.

The optical communication system may include a plurality of optical modules 10, a multiplexer (MUX, 20), and a demultiplexer 30. The plurality of optical modules 10 may each convert electrical signals into optical signals for transmission or convert optical signals received through optical fiber 40 into electrical signals. The multiplexer 20 may convert wavelength signals outputted from a plurality of optical modules 10 into a multiplexed signal for transmission through the optical fiber 40. The demultiplexer 30 may demultiplex an optical signal received through the optical fiber 40 into wavelength signals and transmits each wavelength signal to its respective optical module 10.

Here, the configurations described in FIG. 1 through FIG. 15 may be applicable to the plurality of optical modules 10. This means that the connection of the optical component and the optical fiber through the optical wire facilitate efficient heat dissipation with the coolant.

According to an embodiment, it is possible to improve the optical signal transmission and reception performance by effectively dissipating the heat generated by electronic and optical components placed inside the optical module. It is also possible to improve the reliability and lifespan of the optical module.

## Claims

1. An optical module comprising:
a substrate (210);
an optical component (320) positioned on the substrate (210) and converting an electrical signal into an optical signal or converting an optical into an electrical signal;
an electronic component (310) driving the optical component (320);
an optical fiber (341) support (340) fixing an optical fiber (341) positioned away from the optical component (320);
an optical wire (330) optically connecting the optical component (320) and one end of the optical fiber (341);
a container accommodating the optical component (320), the electronic component (310), and the optical fiber (341) and isolated from the outside; and
coolant filled in the container,
wherein the electronic component (310), the optical component (320), and the optical wire (330) contact the coolant.

2. The optical module of claim 1, wherein the optical fiber (341) support (340) contacts the coolant at one side thereof.

3. The optical module of claim 1 or 2, further comprising a housing accommodating the substrate (210),
wherein the housing comprises:
a second housing (120) accommodating the substrate (210); and
a first housing (110) covering the substrate (210), the first housing (110) being coupled to the substrate (210) to form the container.

4. The optical module of claim 3, wherein the first housing (110) comprises a partition protruding towards the substrate (210) and coupled to the upper surface of the substrate (210) to form the container.

5. The optical module of claim 4, further comprising an adhesive layer formed between the partition and the substrate (210).

6. The optical module of claim 4 or 5, wherein the partition comprises a first partition coupled to the substrate (210) and a second partition coupled to the upper surface of the optical fiber (341) support (340).

7. The optical module of at least one of the preceding claims, further comprising a plurality of heat dissipation patterns arranged within the container and in contact with the coolant.

8. The optical module of claim 7, further comprising a cooling component absorbing heat from the heat dissipation patterns.

9. The optical module of claim 7 or 8, wherein the plurality of dissipation patterns are integrally formed with the housing.

10. The optical module of at least one of the preceding claims, wherein the container comprises a structure withstanding changes in volume due to thermal expansion or contraction inside the container.

11. The optical module of at least one of the preceding claims, wherein the container is connected to a channel through which the coolant circulates outside the container.

12. The optical module of at least one of the claims 3 to 6, wherein the container physically contacts a portion of the housing to dissipate the heat of the coolant to the outside.

13. An optical communication system comprising:
a plurality of optical modules; and
optical fibers connecting the plurality of optical modules,
wherein each of the plurality of optical modules comprises:
a substrate (210); and
an optical component (320) positioned on the substrate (210) and converting an electrical signal into an optical signal or converting an optical into an electrical signal;
an electronic component (310) driving the optical component (320);
an optical fiber (341) support (340) fixing an optical fiber (341) positioned away from the optical component (320);
an optical wire (330) optically connecting the optical component (320) and one end of the optical fiber (341);
a container accommodating the optical component (320), the electronic component (310), and the optical fiber (341) and isolated from the outside; and
coolant filled in the container,
wherein the electronic component (310), the optical component (320), and the optical wire (330) contact the coolant.

14. The optical communication system of claim 13, wherein the optical module further comprises a housing accommodating the substrate (210), wherein the housing comprises: a second housing (120) accommodating the substrate (210); and a first housing (110) covering the substrate (210), the first housing (110) being coupled to the substrate (210) to form the container.

15. The optical module of claim 14, wherein the first housing (110) comprises a partition protruding towards the substrate (210) and coupled to the upper surface of the substrate (210) to form the container.
